Europäisches Patentamt

European Patent Office

Office européen des brevets

(11) Veröffentlichungsnummer : **0 119 281**
**B1**

(12) # EUROPÄISCHE PATENTSCHRIFT

(45) Veröffentlichungstag der Patentschrift :
08.07.87

(51) Int. Cl.⁴ : **G 08 C 19/22, H 03 K 7/08**

(21) Anmeldenummer : 83102431.0

(22) Anmeldetag : 11.03.83

(54) Schaltungsanordnung zur Übertragung von Spannungssignalen.

(43) Veröffentlichungstag der Anmeldung :
26.09.84 Patentblatt 84/39

(45) Bekanntmachung des Hinweises auf die Patenterteilung : 08.07.87 Patentblatt 87/28

(84) Benannte Vertragsstaaten :
AT BE CH DE FR GB IT LI LU NL SE

(56) Entgegenhaltungen :
DE-A- 2 732 298
GB-A- 910 787
US-A- 2 837 642
US-A- 3 705 363
US-A- 4 117 411
ELECTRONIC ENGINEERING, Band 43, Nr. 526,
Dezember 1971, Seiten 36-38, London, GB., A. CIVIT
et al.: I. cs simplify v.-f. and v.-t. conversions"
MEDICAL AND BIOLOGICAL ENGINEERING, Band
13, Nr. 4, Juli 1975, Seiten 544-550, Stevenage, GB.,
I.J.H. DUNCAN et al.: "Radiotelemetry of avian shank
temperature using a thin-film hybrid microcircuit"
IEEE TRANSACTIONS ON INDUSTRIAL ELECTRO-
NICS AND CONTROL INSTRUMENTATION, Band
IECI-26, Nr. 3, August 1979, Seiten 166-172, IEEE, New
York, USA, G. DE MARIA et al.: "Analysis and design
of pulse ratio modulated feedback control systems"

(73) Patentinhaber : **Fritz Fuss Kom.-Ges.**
**Johannes-Mauthe-Strasse 14**
**D-7470 Albstadt 1 (DE)**

(72) Erfinder : **Künzel, Reiner**
**Roschbachstrasse 35**
**D-7460 Balingen/Zillhausen (DE)**

(74) Vertreter : **Weber, Otto Ernst, Dipl.-Phys.**
**Hofbrunnstrasse 36**
**D-8000 München 71 (DE)**

## Beschreibung

Die Erfindung betrifft eine Schaltungsanordnung zur Übertragung von Spannungssignalen von einem Sender über eine Übertragungsstrecke zu einem Empfänger gemäß dem Oberbegriff des Patentanspruchs 1.

Es ist derzeit üblich, analoge Meßwerte mit Analog-Digital-Wandlern zu digitalisieren und über eine Übertragungsstrecke mit Modems zu übertragen, wie sie in ihrem Steuerungsablauf und in der Schnittstelle international genormt sind ; hierzu sei beispielsweise auf die bekannte RS- 232C-Schnittstelle verwiesen. Das Modem beinhaltet im allgemeinen die komplette Steuerung, mit der der Datenverkehr gesteuert wird, sowie einen sychronen oder einen asynchronen Datenpuffer, der senderseitig die anstehenden parallelen Daten zu einem seriellen Bistrom umwandelt und mit Start-, Paritäts- und Stopbits versieht und empfängerseitig den seriellen Datenstrom wieder parallelisiert ; mit einem Digital-Analog-Wandler muß der Meßwert dann zurückgewonnen werden. Für eine industrielle und kommerzielle Datenübertragung mag dieser Aufwand sinnvoll sein. In vielen Fällen ist jedoch eine kostengünstige Datenübertragung und vorzugsweise eine Analogwertübertragung erwünscht und der oben geschilderte Aufwand nicht mehr gerechtfertigt.

Eine Schaltungsanordnung der eingangs genannten Art ist aus der DE-A- 27 32 298 bekannt. Das analoge Eingangssignal, dessen Wert übertragen werden soll, wird dort über einen Widerstand mit dem invertierenden Eingang eines als Integrator verschalteten Operationsverstärkers verbunden, dessen nicht-invertierender Eingang über einen Widerstand an eine erste Versorgungsleitung geht. Der invertierende Eingang ist ferner über einen Widerstand an eine Hilfsspannung gelegt, wobei der Transistor vom Ausgangssignal der Schaltungsanordnung angesteuert wird. Der Ausgang des Integrators ist mit dem invertierenden Eingang eines als Komparator arbeitenden Operationsverstärkers verbunden, dessen nicht-invertierender Eingang über einen Spannungsteiler an einer zweiten und dritten Versorgungsleitung liegt. Es sind also drei Versorgungsspannung und eine Hilfsspannung auf separaten Leitungen erforderlich, um die Funktion der Schaltungsanordnung zu ermöglichen.

Der Erfindung liegt die Aufgabe zugrunde, eine Schaltungsanordnung der eingangs genannten Art zu schaffen, die es gestattet bei sehr geringem Aufwand Spannungs- bzw. Stromsignale störsicher auch über größere Entfernungen durch eine quasi digitale Datenübertragung ohne Verluste zu übertragen, und bei welcher die Zufuhr der Versorgungsspannung vereinfacht ist.

Diese Aufgabe wird gemäß dem kennzeichnenden Teil des Hauptanspruchs gelöst.

Weiterbildungen der Erfindung ergeben sich aus den Unteransprüchen.

Hierbei wird das zu übertragende analoge Signal, beispielsweise die von einem Meßfühler abgeleitete und gegebenenfalls verstärkte Spannung, zunächst zu einer Impulsfolge umgewandelt, bei der das Tastverhältnis $T = t_1/(t_1+t_2)$ proportional dem Augenblickswert des Signalwertes ist und als Impulsfolge auf die Übertragungsstrecke gegeben wird. Im Empfänger wird aus der ankommenden Impulsfolge, deren Tastverhältnis vom Signalwert abhängt, eine diesem Signalwert entsprechende Information durch Siebung mit einem Tiefpaß zurückgewonnen.

Nach dem Grundgedanken der Erfindung wird somit eine Schaltungsanordnung geschaffen, welche senderseitig einen anliegenden analogen Signalwert in ein äquivalentes Tastverhältnis $T = t_1/(t_1 + t_2)$ umwandelt, welches exakt proportional zum anliegenden analogen Signalwert ist.

Dieser quasi digitalisierte Signalwert kann nun verlustlos über größere Entfernungen übertragen werden. Auf der Empfängerseite kann durch einen einfachen aktiven oder passiven Tiefpaß daraus wieder der arithmetische Mittelwert gebildet werden, so daß der am Empfänger zurückgewonnene analoge Signalwert wieder exakt proportional zum ankommenden Tastverhältnis ist, welches den Eingangssignalwert repräsentiert.

Auf der Empfängerseite wird aus der ankommenden Impulsfolge, bei welcher das Tastverhältnis vom anliegenden Signalwert abhängig ist, mit einem aktiven oder einem passiven Tiefpaß durch Mittelwertbildung wieder eine entsprechende proportionale Information zurückgewonnen.

Die gesamte Schaltungsanordnung gemäß der Erfindung ist selbstkompensierend. Dies bedeutet, daß durch Alterungen, Drift, Bauteiländerungen, Betriebsspannungsänderungen oder ähnliche Effekte kein Einfluß auf die Übertragungsgenauigkeit ausgeübt wird.

Mit anderen Worten, gemäß der Erfindung werden senderseitig eine erste Verstärkerstufe als Summations-Integrator und eine zweite Verstärkerstufe als Komparator mit Hysterese so zusammengeschaltet, daß ein anstehender analoger Signalwert in eine äquivalente Impulsfolge mit den oben beschriebenen Eigenschaften umgewandelt wird. Auf der Empfängerseite erfolgt durch einen Tiefpaß eine Mittelwertbildung aus dem Tastverhältnis und damit eine Rückgewinnung des Eingangssignals.

Hierzu lassen sich mit Vorteil die durch die Elektronik zur Verfügung gestellten integrierten Bauelemente verwenden, so daß man eine Anordnung erhält, die sich äußert billig erstellen läßt, aber dennoch eine zuverlässige Meßwertübertragung auch über längere Entfernungen ermöglicht.

Zum Umtasten des aus der Zwei-Draht-Leitung fließenden Stromes dient senderseitig bevorzugt ein zwischen die beiden Drähte gelegter Nebenschlußwiderstand, der in Reihe mit einem Schalter gelegt ist, der mit der erzeugten Impulsfolge angesteuert wird.

Als Stromfühler dient dabei mit Vorteil ein in einen der Drähte der Zwei-Draht-Leitung eingeschleifter Widerstand, dessen impulsförmiger Spannungsabfall ausgewertet wird.

Steuert man weiterhin den Sender mit einer Spannung aus einer Vielzahl von diskreten Spannungswerten an, die innerhalb eines vorbestimmten Wertebereichs festgelegt und jeweils einer vorgegebenen Bedeutung zugeordnet sind, und sieht man weiterhin empfängerseitig als Amplitudendiskriminator beispielsweise einen Fensterkomparator vor, der die von dem Tiefpaß erzeugten diskreten Spannungen auf diesen jeweils zugeordnete Ausgangsfunktion schaltet, ergibt sich mit äußerst einfachen Mitteln eine leistungsfähige Meldeanlage mit der Möglichkeit der Einzelidentifikation mehrer auf eine einzige Übertragungsstrecke bzw. -leitung geschalteter Melder.

Die Erfindung wird nachfolgend unter Bezug auf die beigefügte Zeichnung beschrieben ; es zeigen :

Figur 1 ein Schaltbild einer Schaltungsanordnung nach der Erfindung ;

Figur 2 ein Impulsdiagramm zur Erläuterung der Arbeitsweise der Erfindung ; und

Figuren 3 und 4 Prinzipskizzen für vorteilhafte Ausgestaltungen der Erfindung in zwei Anwendungsfällen.

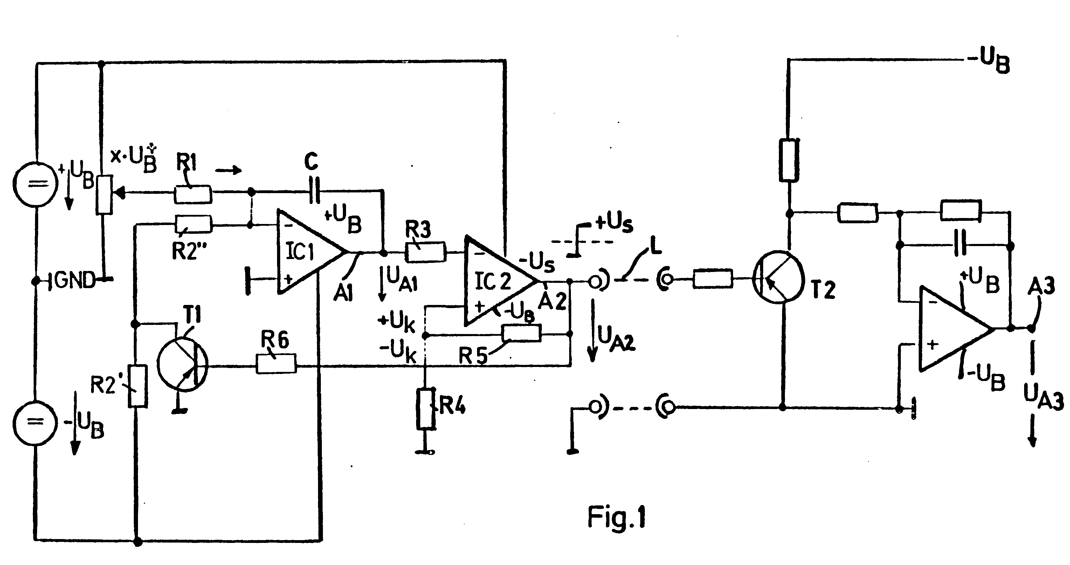

Wie die Fig. 1 zeigt, ist eine Meßspannung zu übertragen, die zur Vereinfachung als $x \cdot U_B$, d. h. als Teil der positiven Betriebsspannung $+ U_B$ dargestellt ist, der mit einem Spannungsteiler oder Potentiometer von der Spannung $+ U_B$ abgeleitet werden könnte. Diese Meßspannung ist über einen Widerstand R1 an den invertierenden Eingang (—) einer Verstärkerstufe IC1 geführt, die als Operationsverstärker ausgebildet sein kann und die in diesem Ausführungsbeispiel mit einer positiven Betriebsspannung ($+ U_B$) und einer negativen Betriebsspannung ($— U_B$) gegen Massepotential GND gespeist wird. Der Ausgang A1 der Verstärkerstufe IC1 ist über einen Kondensator C auf den invertirenden Eingang (—) rückgekoppelt ; die Verstärkerstufe IC1 arbeitet also als Integrator. Der nicht invertierende Eingang (+) der Verstärkerstufe IC1 ist an das Massepotential GND gelegt. Über die Reihenschaltung von zwei Widerständen R2' und R2" ist weiterhin die negative Betriebsspannung ($— U_B$) an den invertierenden Eingang (—) der Verstärkerstufe IC1 geführt. Mit dieser Anordnung entsteht ein Summations-Integrator.

Der Ausgang A1 der Verstärkerstufe IC1 ist über einen Widerstand R3 an den invertierenden Eingang (—) einer zweiten Verstärkerstufe IC2 gelegt, die ebenfalls aus der positiven und der negativen Betriebsspannungsquelle ($+ U_B$, $— U_B$) gespeist wird.

Der Ausgang A2 der zweiten Verstärkerstufe IC2 ist über einen Widerstand R5 mit ihrem nicht invertierenden Eingang (+) verbunden und dieser ist über einen Widerstand R4 an das Massepotential GND gelegt. Die zweite Verstärkerstufe IC2 arbeitet als Komparator mit einem durch das Widerstandsverhältnis R4/R5 gebildeten Hysteresewert.

Weiterhin führt vom Ausgang A2 der zweiten Verstärkerstufe IC2 ein Widerstand R6 an die Basis eines PNP-Transistors T1, der als Schalter arbeitet und den gemeinsamen Anschluß der Widerstände R2' und R2" auf das Massepotential GND legen kann.

Die Anordnung arbeitet wie folgt : Der Widerstand R1 liegt permanent an einer Teilgröße von $U_B$, d. h. an $x \cdot U_B$. Diese Spannung ist an den invertierenden Eingang (—) der als summierender Integrator arbeitenden Verstärkerstufe IC1 gelegt. Es sei zunächst angenommen, daß der Transistor T1 durchgeschaltet ist. Es wird dann der Kondensator C mit einem zeitkonstanten Strom geladen, so daß die Ausgangsspannung $U_{A1}$ des Integrators zeitlinear von $+ U_k$ nach $— U_k$ abfällt. Erreicht nun die Ausgangsspannung $U_{A1}$ des Integrators die Schaltschwelle $— U_k$ des Komparators, springt die Ausgangsspannung $U_{A2}$ des Komparators vom negativen Sättigungswert $U_s$ auf den positiven Sättigungswert $U_{s+}$, so daß der PNP-Transistor T1 gesperrt wird.

Über die Widerstände R2' und R2" liegt nun die negative Betriebsspannung $— U_B$ am Summationspunkt des Integrators, und es erfolgt eine Rückintegration, bis die Ausgangsspannung $U_{A1}$ des Integrators die positive Schaltschwelle $U_k$ des Komparators erreicht hat ; dessen Ausgangsspannung $U_{A2}$ springt dann wieder auf die negative Sättigungsspannung $U_s—$. Der Transistor T1 ist nun wieder durchgeschaltet, und der beschriebene Vorgang beginnt neu.

Die hin und her springende Ausgangsschaltung des Komparators stellt eine Impulsfolge dar, deren Tastverhältnis $T = t_1/(t_1 + t_2)$ gleich der Teilgröße x der Meßspannung an der positiven Betriebsspannung ist (sofern man R1 gleich R2 = R2' + R2" wählt). Das Tastverhältnis ist also ein genaues Maß für die am Schaltungseingang liegende Meßspannung.

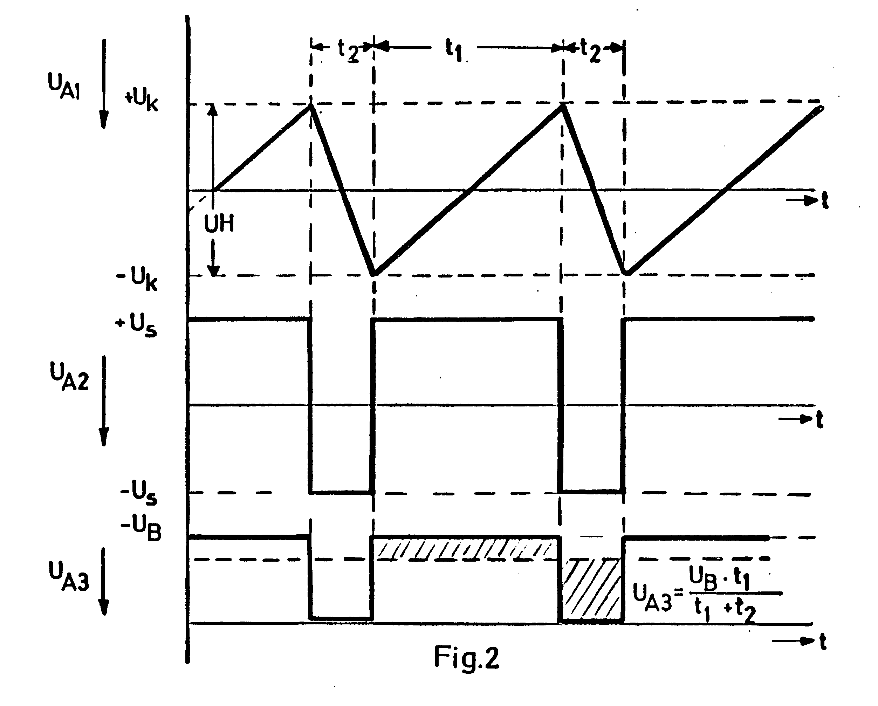

Die auftretenden Signalverläufe sind im Impulsdiagramm der Fig. 2 dargestellt.

Es ist auch möglich, an Stelle von Verstärkern, deren Versorgungsspannungen $+ U_B$, $— U_B$ symmetrisch oder auch unsymmetrisch zum Massepotential liegen, Verstärkerschaltungen zu verwenden, deren positive Versorgungsspannung eine Spannung $+ U_B$ ist und deren negativer Versorgungsanschluß auf das Potential GND gelegt wird. Eine Mittelspannung zwischen den Potentialen $+ U_B$ und GND für den nicht invertierenden Eingang (+) des Verstärkers IC1 läßt sich dann mit einem geeignet bemessenen Spannungsteiler erzeugen.

Die am Ausgang des als Komparator arbeitenden zweiten Verstärkerstufe IC2 stehende Impulsfolge kann nun zum Beispiel unmittelbar auf eine Übertragungsstrecke L in Form einer Drahtleitung an den Empfängereingang gegeben werden. Beim Empfänger handelt es sich im Prinzip um einen Tiefpaß. Durch geeignete Bemessung der Zeitkonstante dieses Tiefpasses erhält man an dessen Ausgang den arithmetischen Mittelwert der an den Eingang gelegten pulsierenden Gleichspannung. Dieser Mittelwert ist dann proportional der Eingangsspannung.

Es gilt : $U_{A3} \sim T \sim E$ wobei $E = x \cdot U_B$ ist.

Die nach der Erfindung erzeugte, dem Meßwert entsprechende Impulsfolge läßt sich auch benutzen, um die Meßwertübertragung mittels einer Funkstrecke durchzuführen. Hierzu ist ein auf einer geeigneten Frequenz schwingender Oszillator mit der Impulsfolge in der Frequenz oder Phase zu modulieren. Empfängerseitig ist dann ein FM- bzw. PM-Demodulator vorgesehen, der eine Impulsfolge liefert, bei der die Flanken in genau der gleichen zeitlichen Zuordnung auftreten wie in der modulierenden Impulsfolge im Sender.

Als Übertragungsstrecke kann über einen geeigneten Netzadapter auch das 220-Volt Stromnetz dienen.

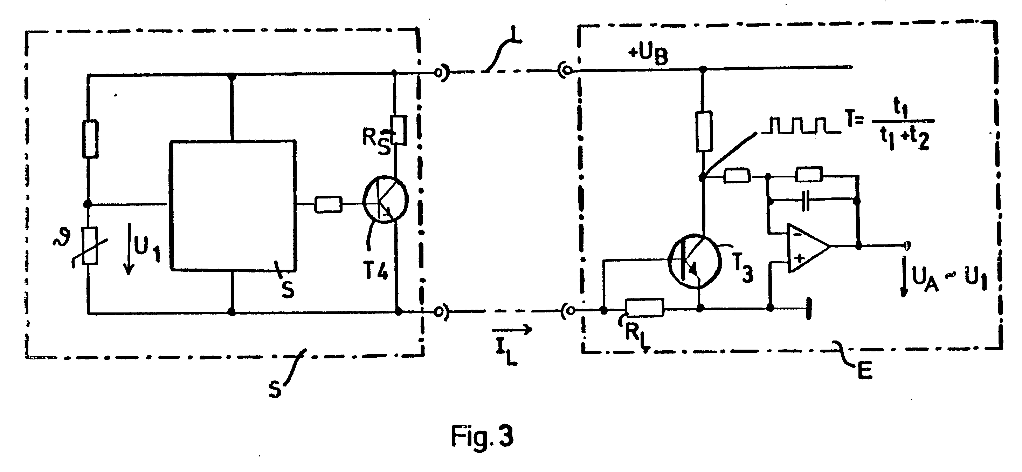

Die Fig. 3 der Zeichnung zeigt als Beispiel für die Übertragungsstrecke L eine einfache Zwei-Draht-Leitung, die vorteilhafterweise auch zur Zufuhr der Versorgungsspannung $U_B$ aus der zentralen Empfangseinheit E an den abgesetzten Sender S dienen kann ; es entfällt dann die ansonsten erforderliche separate Stromversorgung für den Sender. Dabei verwendet man die im Sender S erzeugte Impulsfolge bevorzugt zur Ansteuerung von Schaltungsmitteln, mit denen der auf der Zwei-Draht-Leitung fließende Strom definiert zwischen zwei Stromwerten hin und her geschaltet, d. h. umgetastet wird. Eine hierzu geeignete Anordnung ist beispielsweise ein in Reihe mit einem Schalter zwischen den beiden Adern der Leitung liegender Nebenanschlußwiderstand $R_S$ (Fig. 3). Dieser Schalter, bei dem es sich vorzugsweise um einen Transistor T4 (Fig. 3) handelt, wird mit der Senderimpulsfolge angesteuert und bewirkt betrieblich einen Laststrom $I_L$, der zwischen zwei Stromwerten hin- und herspringt, wobei die Abstände zwischen den Sprüngen genau den Flankenabständen der ansteuernden Impulsfolge entsprechen. Empfängerseitig ist ein Stromfühler vorgesehen, der in der hier dargestellten Ausführungsform ein in eine der Adern der Leitung eingeschleifter Widerstand $R_L$ ist, dessen Spannungsabfall ebenfalls impulsförmig ist. Legt man über diesen Widerstand $R_L$ beispielsweise die Basis-Emitter-Strecke eines Transistors, wird der Transistor T3 entsprechend den ankommenden Stromimpulsen leitend oder gesperrt. Die sich am Kollektor des Transistors ergebenden Impulse entsprechen in der zeitlichen Flankenfolge derjenigen der Senderimpulse ; ihr Tastverhältnis ist proportional der Meßspannung. Durch Tiefpaßfilterung erhält man aus ihnen den Meßwert zurück.

Bei der Meßspannung kann es sich um die Spannung handeln, die ein auf eine physikalische Größe (Temperatur, Druck, usw.) ansprechender Meßfühler liefert und die verstärkt werden kann.

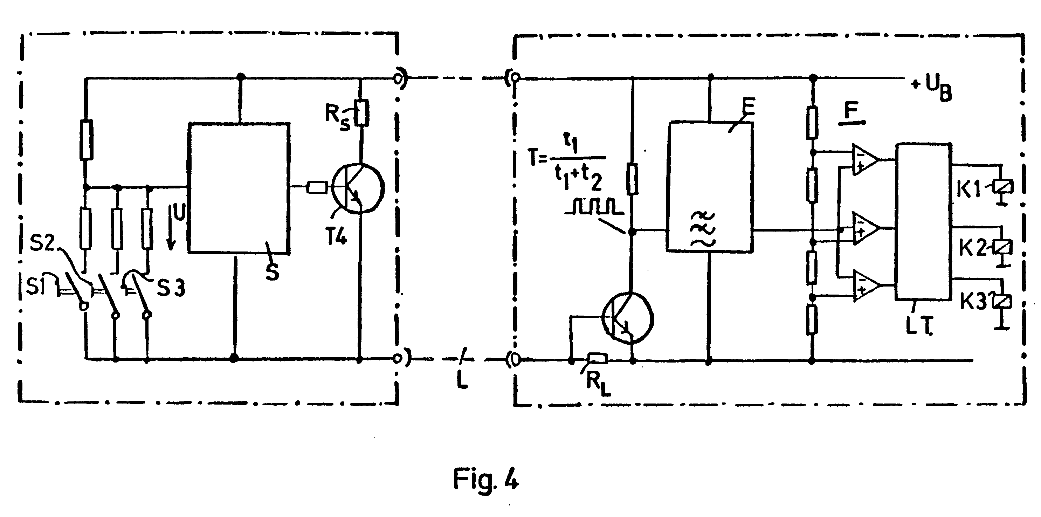

Wie die Fig. 4 zeigt, ist es auch zu Meldezwecken möglich, die das Tastverhältnis der als Übertragungssignal dienenden Impulsfolge bestimmende Spannung im Sender S nicht stetig, sondern diskret gestuft zu wählen, wie in der Fig. 4 mit den Schaltern S1 bis S3 gezeigt wird. Dabei entsteht am Eingang des Senders S eine Spannung U, die sich aus dem mit einem der Schalter und dem durch diesen eingelegten Widerstand bestimmten Spannungsteilerverhältnis ergibt. Je nach dem eingelegten der Schalter S1 bis S3 wird eine Impulsfolge mit einem bestimmten Tastverhältnis gebildet und auf der auch hier als Zwei-Draht-Leitung vorliegenden Übertragungsstrecke L als Stromumtastsignal zum Empfänger E übertragen. Der Schalttransistor T4, der Nebenschlußwiderstand $R_s$ und der als Stromfühler dienende Widerstand $R_L$ üben dabei die gleichen Funktionen aus wie in der in der Fig. 3 dargestellten Ausführungsform der Erfindung. Im Empfänger E werden vom Tiefpaßfilter proportional zum Tastverhältnis der ankommenden Impulsfolge Ausgangsspannungen mit diskreten Werten erzeugt, die sich in einem als Amplitudendiskriminator arbeitenden Fensterkomparator F quasi digitalisieren und über eine Auswertelogik- und Treiberstufe LT zur Signalgabe in einem dem jeweils eingelegten senderreitigen Schalter S1 bis S3 zugeordneten Kanal nutzen lassen, beispielsweise zur Erregung eines der Schaltrelais K1 bis K3.

Man erhält mit einer Anordnung nach Fig. 4 die Möglichkeit der Einzelidentifikation mehrerer auf eine gemeinsame Meldeleitung geschalteter Melder. Dieser Gesichtspunkt ist in der Gefahrenmeldetechnik wesentlich, wenn der für eine Meldeanlage zu treibende Aufwand nicht die zu erreichende Sicherheit beeinträchtigen darf.

**Patentansprüche**

1. Schaltungsanordnung zur Übertragung von Spannungssignalen von einen Sender (S) über eine Übertragungsstrecke (L) zu einem Empfänger (E), mit einer senderseitigen ersten Verstärkerstufe (IC1) mit einem invertierenden und einem nichtinvertierenden Eingang, deren Ausgang über einen Kondensator (C) an den invertierenden Eingang rückgeführt ist, an deren invertierenden Eingang über eine Reihenschaltung zweier Widerstände (R2', R2") eine auf einer ersten Leitung anliegende negative Betriebsspannung (— $U_B$) und das Spannungssignal über einen Widerstand (R1) gelegt sind, und deren nicht-invertierender Eingang auf das Massepotential (GND) zwischen der negativen und einer auf einer zweiten Leitung anliegenden positiven Betriebsspannung (— $U_B$, + $U_B$) gelegt ist und mit einer zweiten Verstärkerstufe (IC2) mit einem invertierenden und einem nicht-invertierenden Eingang, dadurch gekennzeichnet, daß der invertierende Eingang der zweiten Verstärkerstufe (IC2) über einen Widerstand (R3) mit dem Ausgang der ersten Verstärkerstufe (IC1) verbunden ist und deren Ausgangssignal zum Empfänger (E) übertragen wird, daß der Ausgang der zweiten Verstärkerstufe (IC2) über eine Reihenschaltung von zwei Widerständen (R4, R5) an das Massepotential (GND) und deren Verbindungspunkt an den nicht-invertierenden Eingang der zweiten Verstärkerstufe (IC2) gelegt sind, daß zwischen der ersten und zweiten Leitung ein vom Ausgang der zweiten Verstärkerstufe (IC2) angesteuerter Schalter (T1) zur Umtastung des auf den beiden Leitungen fließenden Stromes liegt daß die Übertragungsstrecke (L) aus der ersten und zweiten Leitung besteht, daß die erste und zweite Leitung empfängerseitig an einen Stromfühler (Widerstand R$_L$), dem ein Tiefpaßfilter nachgeschaltet ist, liegt, und daß der Sender (S) über die erste und zweite Leitung mit Betriebsspannung versorgt ist.

2. Schaltungsanordnung nach Anspruch 1, dadurch gekennzeichnet, daß zwischen die beiden Leitungen der Übertragungsstrecke (L) die Reihenschaltung aus einem Widerstand (Rs) mit einem Schalter (T4) gelegt ist und daß der Schalter mit dem Ausgangssignal der zweiten Verstärkerstufe (IC2) angesteuert wird.

3. Schaltungsanordnung nach Anspruch 1 oder 2, dadurch gekennzeichnet, daß empfängerseitig in eine der Leitungen der Übertragungsstrecke (L) als Stromfühler ein Widerstand (R$_L$) eingeschleift ist, dessen Spannungsabfall als Nutzsignal dient.

4. Schaltungsanordnung nach einem der vorhergehenden Ansprüche, dadurch gekennzeichnet, daß der Sender (S) jeweils mit einer Spannung aus einer Vielzahl von diskreten Spannungswerten gespeist wird, die innerhalb eines vorbestimmten Wertebereichs festgelegt und jeweils einer vorgegebenen Bedeutung zugeordnet sind, und daß empfängerseitig ein Fensterkomparator (F) vorgesehen ist, der die vom Tiefpaß erzeugten diskreten Spannungen auf diesen jeweils zugeordneten Ausgangsfunktionen schaltet.

## Claims

1. Circuitry for transmitting voltage signals from a transmitter (S), across a transmitting link (L) to a receiver (E), with a transmitter-side first amplifier stage (IC1) with an inverting and a non-inverting input, whose output is returned across a capacitor (C) to the inverting input, to whose inverting input is applied a negative operating voltage (— U$_B$) on a first line across a series connection of two resistors (R2', R2") and across a resistor (R1) the voltage signal and whose non-inverting input is at the earth potential (GND) between the negative operating voltage (— U$_B$) and a positive operating voltage (+ U$_B$) on a second line and with a second amplifier stage (IC2) with an inverting and a non-inverting input, characterized in that the inverting input of the second amplifier stage (IC2) is connected across a resistor (R3) to the output of the first amplifier stage (IC1) and whose output signal is transmitted to receiver (E), that the output of the second amplifier stage (IC2) is applied across a series connection of two resistors (R4, R5) to earth potential (GND) and whose connecting point is applied to the non-inverting input of the second amplifier stage (IC2), that between the first and second lines is provided a switch (T1) actuated by the output of the second amplifier stage (IC2) for switching the current flowing on one of the two lines, that the transmission link (L) comprises the first and second lines, that the first and second lines on the receiver-side are at a current sensor (resistor R$_L$), which is followed by a low-pass filter and that the transmitter (S) is supplied with operating voltage across the first and second lines.

2. Circuitry according to claim 1, characterized in that the series connection of a resistor (Rs) and a switch (T4) is applied between the two lines of the transmitting link (L) and that the switch is actuated by the output signal of the second amplifier stage (IC2).

3. Circuitry according to claims 1 or 2, characterized in that on the receiver-side a resistor (R$_L$) is incorporated as the current sensor into one of the lines of the transmitting link (L) and its voltage drop serves as the information signal.

4. Circuitry according to one of preceding claims, characterized in that the transmitter (S) is supplied by a voltage from a plurality of discrete voltage values fixed within a predetermined value range and in each case associated with a predetermined significance and that on the receiver-side is provided a window comparator (F), which switches the discrete voltages produced by the low-pass filter to output functions associated therewith.

## Revendications

1. Dispositif de circuit pour transmettre des signaux de tension depuis un émetteur (S), par l'intermédiaire d'une ligne de transmission (L) à un récepteur (E), comportant, côté émetteur, un premier étage amplificateur (IC1) qui présente une entrée d'inversion et une entrée de non-inversion, dont la sortie est reliée, pour rétroaction, par l'intermédiaire d'un condensateur (C) à l'entrée d'inversion, à l'entrée d'inversion duquel arrivent, par l'intermédiaire d'un circuit de série constitué de deux résistances (82', 82"), une tension d'exploitation négative (— U$_B$) qui se trouve sur un premier conducteur et, par l'intermédiaire d'une résistance (R1), le signal de tension, et dont l'entrée de non-inversion est mise au potentiel de masse (GND) entre la tension d'exploitation négative et une tension d'exploitation positive qui se trouve sur un second conducteur (— U$_B$, + U$_B$), et comportant également un second étage amplificateur (IC2) avec une entrée d'inversion et une entrée de non-inversion, caractérisé en ce que l'entrée d'inversion du second étage amplificateur (IC2) est reliée, par l'intermédiaire d'une résistance (R3), à la sortie du premier étage amplificateur (IC1) et en ce que son signal de sortie est transmis au récepteur (E) ; en ce que la sortie du second étage amplificateur (IC2) est mise, par l'intermédiaire d'un circuit de série constitué de deux résistances (R4, R5), au potentiel de masse (GND) et en ce que leur point de liaison est relié l'entrée de non-inversion du second étage amplificateur (IC2) ; en ce qu'entre le premier conducteur et le second conducteur se trouve un interrupteur (T1) piloté par le signal de sortie du second étage amplificateur (IC2) pour faire commuter le courant qui s'écoule sur les deux conducteurs ; en ce que la ligne de transition (L) est constituée du premier conducteur et du second conducteur ; en ce que le premier conducteur et le second conducteur arrivent, côté récepteur, à un détecteur de courant (résistance R$_L$) en aval duquel est monté un filtre passe-bas, et en ce que l'émetteur (S) est alimenté en tension d'exploitation par l'intermédiaire du premier conducteur et du second conducteur.

2. Dispositif de circuit selon la revendication 1, caractérisé, en ce qu'entre les deux conducteurs de la ligne de transmission (L) est placé le circuit de série constitué d'une résistance (Rs) avec un interrupteur (T4) ; et en ce que l'interrupteur est piloté par le signal de sortie du second étage amplificateur (IC2).

3. Dispositif de circuit selon la revendication 1 ou 2, caracterisé, en ce que, du côté récepteur, dans l'un des conducteurs de la ligne de transmission (L) est bouclée, pour servir de détecteur de courant, une résistance (R$_L$) dont la chute de tension aux bornes sert de signal utile.

4. Dispositif de circuit selon l'une des revendications précédentes, caractérisé, en ce que l'émetteur (S) est respectivement alimenté avec une tension prise parmi un grand nombre de valeurs discrètes de tension qui sont définies à l'intérieur d'une plage de valeurs prédéterminée et qui correspondent respectivement à une signification prescrite ; et en ce que, côté récepteur, est prévu un comparateur à fenêtre (F) qui commute les tensions discrètes produites par le filtre passe-bas sur les fonctions de sortie respectivement correspondantes.

Fig.1

Fig.2

$$U_{A3} = \frac{U_B \cdot t_1}{t_1 + t_2}$$

0 119 281

Fig. 3

$T = \dfrac{t_1}{t_1 + t_2}$

$U_A \sim U_1$

0 119 281

Fig. 4

$$T = \frac{t_1}{t_1 + t_2}$$